# EUROPÄISCHE PATENTANMELDUNG

(11) **EP 0 875 941 A2**
(43) Veröffentlichungstag der Anmeldung: **04.11.1998**
(21) Anmeldenummer: 98107231.7
(22) Anmeldetag: 21.04.1998
(51) Int. Cl.: H01L 29/737, H01L 29/08

(54) **Heterobipolartransistor mit Mehrschicht-Emitterstruktur**

(30) Priorität: 02.05.1997 DE 19718624
(71) Anmelder: DAIMLER-BENZ AKTIENGESELLSCHAFT, 70546 Stuttgart (DE)
(72) Erfinder: Leier, Helmut, Dr., 73344 Gruibingen (DE)

(57) **Zusammenfassung**

Die Erfindung betrifft einen Heterobipolartransistor mit einer Mehrschicht-Emitterstruktur und ein Verfahren zu deren Herstellung. Die Emitterschichtenfolge enthält zumindest eine Emitterschutzschicht und eine darüber angeordnete Ätzstoppschicht. Die Halbleitermaterialien für die Emitterschutzschicht und die darunterliegende Basisschicht sind so gewählt, daß die Halbleiterschichten im Emitter-/Basisbereich defektfrei und gitterangepaßt gewachsen sind.

## Beschreibung

Die Erfindung betrifft einen Heterobipolartransistor mit einer Mehrschicht-Emitterstruktur und ein Verfahren zu deren Herstellung nach den Oberbegriffen der Patentansprüche 1 und 5.

Die Erfindung findet Verwendung in Hochfrequenzschaltkreisen insbesondere in Leistungsverstärkern, Oszillatoren und Mischem. Derartige Schaltkreise werden u.a.in Systemen für die mobile Kommunikation und bei phasengesteuerten Radaranlagen eingesetzt.

Aus Veröffentlichungen von C.Dubon-Chevallier in Electronics Letters, Vol.28, S. 2308 (1992) und in der US-Patentschrift 5,412,233 sind Heterobipolartransistoren bekannt, die eine Mehrschicht-Emitterstruktur mit einer GaInP-Schutzschicht aufweisen. Die GaInP-Schicht ist dabei direkt auf die GaAs-Basis aufgewachsen. Dies hat den Nachteil, daß eine Gitterfehlanpassung leicht möglich ist und Gitterdefekte im Emitter-/Basisbereich auftreten können.

Aufgabe der Erfindung ist deshalb einen Heterobipolartransistor (HBT) mit einer Emitterstrukur und ein Verfahren anzugeben, die die Zuverlässigkeit von HBT's erhöht und das Herstellungsverfahren vereinfacht.

Die Erfindung ist in den Patentansprüchen 1 und 5 angegeben. Vorteilhafte Ausgestaltungen und Weiterbildungen sind den Unteransprüchen zu entnehmen.

Die Erfindung hat den Vorteil, daß bei Verwendung einer z.B. GaAs-Basis durch eine Emitterschichtenfolge mit einer AlGaAs-Schutzschicht, die auf die GaAs-Basis aufgebracht ist, ein gitterangepaßter Emitter-/Basisbereich gebildet wird, der defektfrei gewachsen werden kann und eine längere Lebensdauer des HBT bewirkt.
Weiterhin ist von Vorteil, daß eine GaInP-Ätzstoppschicht in die Emitterschichtenfolge in genügend großem Abstand von der Rekombinationszone enthalten ist, mit der ein kontrollierbarer Ätzstopp auf der Schutzschicht erzielt wird, und gleichzeitig unerwüschte Rekombinationsprozesse vermieden werden. Da für den Ätzstopp lediglich dünne Schichten notwendig sind, ist bei Verwendung einer dünnen GaInP-Schicht als Ätzstopp die Möglichkeit von Gitterverspannungen sehr gering.
Die Erfindung wird im folgenden anhand von Ausführungsbeispielen näher erläutert unter Bezugnahme auf schematische Zeichnungen.

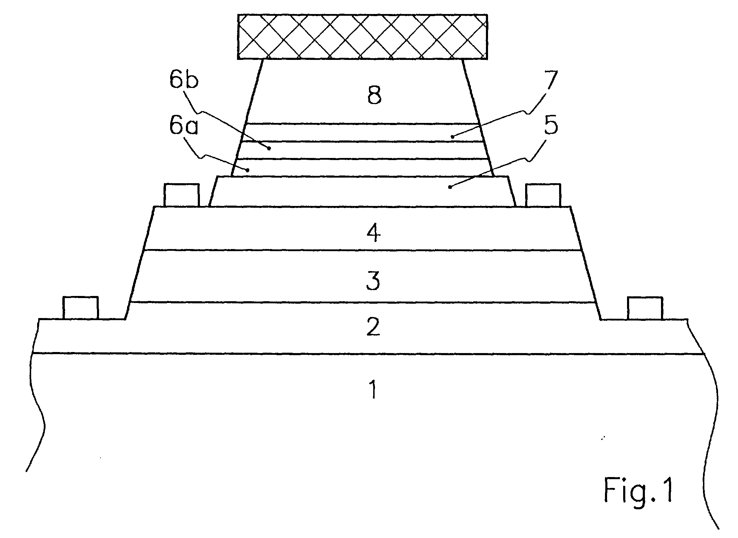

In Fig. 1 ist ein beispielhafter HBT dargestellt, bei dem auf einem Substrat 1, z.B. aus GaAs, eine Sub-Kollektorschicht 2 aus z.B. GaAs mit einer Schichtdicke von 0,6 µm und n-Dotierkonzentration von 5·10¹⁸cm⁻³, einer Kollektorschicht 3 aus z.B. GaAs mit einer Schichtdicke von 0,8µm und einer n-Dotierkonzentration von 2·10¹⁶cm⁻³ und einer Basisschicht 4 aus z.B.GaAs mit einer Schichtdicke von 0,1 µm und einer p-Dotierkonzentration von 2 bis 5·10¹⁹cm⁻³ aufgewachsen ist.
Auf die Basisschicht 4 ist beispielsweise eine Emitter-Schutzschicht 5 aus AlₓGa₁₋ₓ As mit x= 0,3 und einer Schichtdicke von 40 nm und einer n-Dotierkonzentration von 2 10¹⁷cm⁻³ aufgebracht. Auf die Schutzschicht 5 ist eine Übergangsschicht 6a aus AlₓGa₁₋ₓ As mit 0,3<x>0 und einer Schichtdicke von 10nm und einer n-Dotierung von 2 10¹⁷ cm⁻³ eingefügt. Es folgt eine GaAs Pufferschicht 6b mit einer Schichtdicke von 0,01 µm und einer n-Dotierkonzentration von 2 10 ¹⁷ cm ⁻³ . Daran anschließend ist eine Ätzstoppschicht 7 aus GaInP mit einer Schichtdicke von 15 nm und einer n-Dotierkonzentration von 4-8 10¹⁷ cm⁻³ aufgebracht. Eine Emitterkontaktschicht 8 aus GaAs mit einer Schichtdicke 200nm und einer n-Dotierkonzentration von 3·10¹⁸cm⁻³ bildet die Deckschicht der Emitterschichtenfolge.

Auf der Basisschicht 4 kann auch eine Emitterschichtenfolge aus einer Schutzschicht aus AlGaAs mit einer Schichtdicke von 0,03 bis 0,05 µm mit einer Dotierkonzentration von 1 bis 4 10¹⁷cm⁻³, einer Übergangsschicht aus AlGaAs mit einer Schichtdicke von 0,01 bis 0,02 µm mit einer n-Dotierkonzentration 1 bis 4 10¹⁷ cm⁻³, einer Pufferschicht aus GaAs mit einer Schichtdicke von 0,01 bis 0,02 µm und einer n-Dotierkonzentration 2 bis 6 10 ¹⁷cm ⁻³ und einer Ätzstoppschicht aus GaInP wie im vorhergehenden Beispiel aufgebracht werden. Der Emitterkontakt kann aus mehreren Schichten bestehen, z.B. aus einer GaAs-Schicht mit einer Schichtdicke von 0,2µm und einer Dotierkonzentration von 3·10¹⁸ cm⁻³ und einer InGaAs-Schicht mit einer Schichtdicke von 0,03µm und einer Dotierkonzentration von 3·10¹⁹cm⁻³ . Der In-Gehalt steigt hierbei von 0% auf bis zu 50% an der Oberfläche der Schicht an.

Die Emitterschichtenfolge kann auch ohne die angegebenen Pufferschichten ausgebildet werden. Die Pufferschichten dienen lediglich zur Herstellung einfacher Grenzflächen.

Die Halbleiterschichten werden mit gängigen Epitaxie-Verfahren hergestellt.

Zur Ausbildung der Emitterstruktur wird die Emitterschichtenfolge derart selektiv geätzt, daß die Ätze aufder GaInP-Stoppschicht stoppt. Die GaInP-Schicht wird selektiv mit einer weiteren Ätze entfernt. Durch einen nachfolgenden gut kontrollierbaren flachen Ätzschritt (Ätz-dip) kann die AlGaAs-Übergangsschicht entfernt werden. Anschließend werden die metallischen Kontakte hergestellt.

Die Erfindung ist nicht auf die in den Ausführungsbeispielen angegebenen Materialien und Substrate beschränkt. Um bzgl. Defektfreiheit und Gitteranpassung optimierte Emitter-/Basisübergänge zu erhalten, kann z.B. die Basisschicht aus InGaAs, die Emitterschutzschicht aus InAlAs und die Ätzstoppschicht aus InP bestehen. Als Substrat wird InP verwendet.

## Patentansprüche

1. Heterobipolartransistor mit einer Emitterschichtenfolge, die zumindest eine Emitterschutzschicht und eine Ätzstoppschicht enthält, dadurch gekennzeichnet, daß die Emitterschutzschicht auf der Basisschicht aufgebracht ist, daß das Halbleitermaterial der Emitterschutzschicht derart gewählt ist, daß die Halbleiterschichten im Emitter-/Basisbereich defektfrei gewachsen und gitterangepaßt sind, und daß die Ätzstoppschicht oberhalb der Emitterschutzschicht angeordnet ist.

2. Heterobipolartransistor nach Anspruch 1, dadurch gekennzeichnet, daß die Emitterschutzschicht aus AlGaAs und die Basisschicht aus GaAs besteht.

3. Heterobipolartransistor nach Anspruch 1 und 2, dadurch gekennzeichnet, daß die Emitterschichtenfolge aus einer AlGaAs-Schutzschicht, AlGaAs-Übergangsschicht, GaAs-Pufferschicht, GaInP-Ätzstoppschicht und mindestens einer Kontaktschicht besteht.

4. Heterobipolartransistor nach einem oder mehreren der vorhergehenden Ansprüche, dadurch gekennzeichnet, daß die Ätzstoppschicht eine Schichtdicke von 5 bis 50 nm besitzt.

5. Verfahren zur Herstellung einer Emitterstruktur für einen Heterobipolartransistor nach einem der vorhergehenden Ansprüche, dadurch gekennzeichnet, daß die Emitterschichten derart selektiv geätzt werden, daß die Ätze auf der AlGaAs-Schutzschicht stoppt.
